(19) **Europäisches Patentamt / European Patent Office / Office européen des brevets**

(11) **EP 2 919 140 A1**

(12) **EUROPEAN PATENT APPLICATION**

(43) Date of publication:
16.09.2015 Bulletin 2015/38

(51) Int Cl.:
*G06F 17/50* (2006.01)    *B29C 45/76* (2006.01)

(21) Application number: 15158024.8

(22) Date of filing: 06.03.2015

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: 10.03.2014 JP 2014046965

(71) Applicant: **FUJITSU LIMITED**
**Kawasaki-shi,**
**Kanagawa 211-8588 (JP)**

(72) Inventor: **Kazama, Masaki**
**Kawasaki-shi, Kanagawa 211-8588 (JP)**

(74) Representative: **Wilding, Frances Ward**
**Haseltine Lake LLP**
**Lincoln House, 5th Floor**
**300 High Holborn**
**London WC1V 7JH (GB)**

(54) **Apparatus, method, and computer readable storage medium storing a program for simulating injection molding**

(57)    A simulation apparatus includes: a memory; and a processor coupled to the memory, wherein the processor executes a time change process of calculating time changes of fluid particles by a particle method, a repulsive force process of calculating repulsive force acting on the particles due to a wall surface potential of a boundary particle which is disposed in an inflow port of a mold to be analyzed and which represents a change of a pressure in the inflow port, a position process of calculating a position of the boundary particle in accordance with an internal pressure of the mold which is reaction of the calculated repulsive force and an external pressure which injects the particles to the mold, and a particle process of generating or removing the particles in accordance with a position of the boundary particle.

FIG. 12

EP 2 919 140 A1

**Description**

FIELD

The embodiment discussed herein is related to a simulation apparatus, a simulation method, and a computer readable storage medium storing a simulation program.

BACKGROUND

As a numerical calculation method for solving a continuum, such as fluid or an elastic body, a finite difference method, a finite element method, a finite volume method, and the like for obtaining an approximate solution of a differential equation using mesh are widely used. In recent years, such numerical calculations are applied to an application field of computer aided engineering (CAE) and the like, and used for analyzing a problem in which fluid and a structure interact with each other. The methods using mesh are complicated in a case where a problem of presence of a certain boundary face, such as a free surface, arises or in a case where a moving boundary of a fluid-structure interaction problem or the like is generated. Furthermore, when the methods using mesh described above are employed, programs may be difficult to be generated in these cases.

On the other hand, a particle method has been widely used in recent years since a special process is not used to cope with a moving boundary. When a boundary condition of a moving boundary or the like is addressed by the particle method, in a case of a wall surface, a wall is represented by fixed particles which block fluid and in a case of a boundary in which fluid freely flows out, particles which cross the boundary are removed. Furthermore, in the particle method, when inflow of fluid at a certain speed is to be realized, a boundary condition in which particles are generated at a predetermined time interval from the boundary and thereafter inflow of the particles is enabled may be adopted.

However, in the boundary condition described above, a pressure boundary condition in which a setting of a pressure is to be performed, such as a case where an external pressure is applied from an outside to an inside of a boundary through the boundary, may not be realized. Therefore, to realize the pressure boundary condition, a region larger than a region in an inside of the boundary is provided in an outside of the boundary, a numerical calculation is performed also on the region in the outside of the boundary, and an amount of inflow from the outside to the inside of the boundary is calculated. Accordingly, a calculation time is increased.

The present disclosure provides a simulation apparatus and a simulation method which enable high-speed simulation and a computer readable storage medium storing a simulation program.

SUMMARY

According to an embodiment of an aspect of the invention, a simulation apparatus includes: a memory; and a processor coupled to the memory, wherein the processor executes a time change process of calculating time changes of fluid particles by a particle method, a repulsive force process of calculating repulsive force acting on the particles due to a wall surface potential of a boundary particle which is disposed in an inflow port of a mold to be analyzed and which represents a change of a pressure in the inflow port, a position process of calculating a position of the boundary particle in accordance with an internal pressure of the mold which is reaction of the calculated repulsive force and an external pressure which injects the particles to the mold, and a particle process of generating or removing the particles in accordance with a position of the boundary particle.

BRIEF DESCRIPTION OF DRAWINGS

The invention is described, by way of example only, with reference to the following drawings, in which:

FIG. 1 is a block diagram illustrating a configuration of a simulation apparatus according to an embodiment;
FIG. 2 is a diagram illustrating fluid injection by a pressure;
FIG. 3 is a diagram illustrating a pressure applied on a boundary surface;
FIG. 4 is a diagram illustrating a case where an external pressure overcomes an internal pressure;
FIG. 5 is a diagram illustrating a case where an internal pressure overcomes an external pressure;
FIG. 6 is a diagram illustrating the relationship between a boundary particle and an external pressure;
FIG. 7 is a diagram illustrating force acting on the boundary particle;
FIG. 8 is a diagram illustrating a calculation condition of force acting on the boundary particle;
FIG. 9 is a diagram illustrating repulsive force acting on a particle due to a wall surface potential of the boundary particle;
FIG. 10 is a diagram illustrating generation of particles on a boundary surface;

FIG. 11 is a diagram illustrating removal of particles on a boundary surface;

FIG. 12 is a flowchart illustrating a process performed by the simulation apparatus according to the embodiment; and

FIG. 13 is a diagram illustrating a computer which executes a simulation program.

DESCRIPTION OF EMBODIMENT

Hereinafter, an embodiment of a simulation apparatus, a simulation method, and a simulation program disclosed in this application will be described in detail with reference to the accompanying drawings. The disclosed technique is not limited to the embodiments. Furthermore, examples of the embodiment may be appropriately combined with one another as long as consistency is maintained.

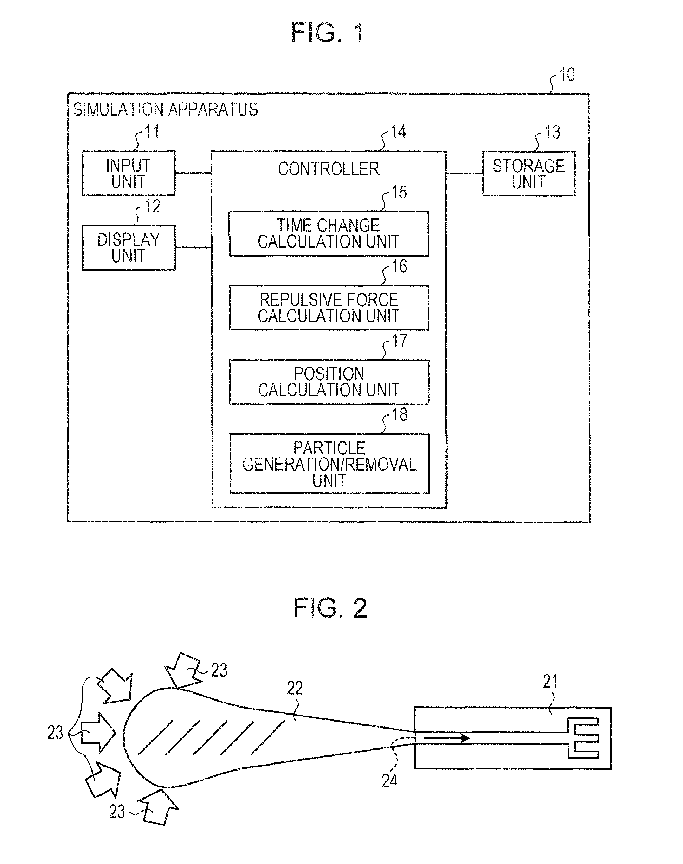

FIG. 1 is a block diagram illustrating a configuration of a simulation apparatus according to an embodiment. A simulation apparatus 10 of FIG. 1 includes an input unit 11, a display unit 12, a storage unit 13, and a controller 14. The simulation apparatus 10 may include, in addition to the functional units illustrated in FIG. 1, various functional units included in general computers, such as various input devices and various audio output devices.

The input unit 11 accepts inputs of various types of input data to be used for simulation of fluid performed in accordance with the particle method. The input unit 11 accepts data on a shape of a simulation calculation region, fluid data, a maximum inflow velocity $v_{max}$ of a particle relative to the simulation calculation region, an external pressure $P_e$ for flowing the fluid into the calculation region, an area S of an inflow port, and the like. The input data may be input by a user who uses the simulation apparatus 10 or input through an external storage medium or a communication line. The input unit 11 outputs the shape data, the fluid data, the maximum inflow velocity $v_{max}$, the external pressure $P_e$, and the area S of the inflow port to the controller 14 as obtained data externally input.

The display unit 12 displays a result of simulation. A result of simulation calculated by a time change calculation unit 15 described below of the controller 14 is supplied to the display unit 12 which displays the simulation result as a simulation image, for example.

The storage unit 13 is realized by a semiconductor memory element, such as a random access memory (RAM) or a flash memory, or a storage device, such as a hard disk or an optical disc. The storage unit 13 stores the simulation result and information used in a process performed by the controller 14.

The controller 14 is realized when a program stored in an internal storage device is executed by a central processing unit (CPU), a micro processing unit (MPU), or the like using the RAM as a work space. Alternatively, the controller 14 may be realized by an integrated circuit, such as an application specific integrated circuit (ASIC) or a field programmable gate array (FPGA). The controller 14 includes the time change calculation unit 15, a repulsive force calculation unit 16, a position calculation unit 17, and a particle generation/removal unit 18, and realizes and executes information processing functions and information processing operations described below. An internal configuration of the controller 14 is not limited to the configuration illustrated in FIG. 1, and other configurations may be employed as long as information processing described below is performed.

The time change calculation unit 15 performs a calculation of simulation of fluid using the shape data, the fluid data, and so on input by the input unit 11 in accordance with algorithm of the particle method. The time change calculation unit 15 determines a simulation calculation region in accordance with the shape data. Furthermore, the time change calculation unit 15 performs the calculation of the simulation of fluid after reflecting particle data supplied from the particle generation/removal unit 18. The time change calculation unit 15 performs the calculation of the simulation of fluid in accordance with a smoothed particle hydrodynamics (SPH) method, for example, as the algorithm of the particle method. In the SPH method, an equation of fluid which is slightly compressed is discretized in accordance with Expressions (1) to (3). In Expressions (1) to (3), time change members are represented on a right-hand side.

$$\frac{d\rho_i}{dt} = \sum_j m_j (v_i - v_j) \cdot \frac{\partial W(|x_i - x_j|)}{\partial x_i} \qquad \cdots (1)$$

$$\frac{dv_i}{dt} = g - \sum_j m_j \left[ \left( \frac{p_j + p_i}{\rho_j \rho_i} \right) - \frac{\xi}{\rho_j \rho_i} \frac{4\mu_i \mu_j}{(\mu_i + \mu_j)} \frac{v_{ij} \cdot x_{ij}}{|x_{ij}|^2 + \eta^2} \right] \frac{\partial W(|x_i - x_j|)}{\partial x_i} \qquad \cdots (2)$$

$$p_i = P_0\left[\left(\frac{\rho_i}{\rho_0}\right)^\gamma - 1\right] \qquad \cdots (3)$$

Expression (1) described above represents the law of conservation of mass, Expression (2) described above represents the law of conservation of momentum (an equation of motion), and Expression (3) described above represents an equation of state. Here, "$x_i$" denotes a position vector of a particle i, "$v_i$" denotes a velocity vector of the particle i, $\rho_i$ denotes density of the particle i, "$m_i$" denotes a mass of the particle i, and "$p_i$" denotes a pressure of the particle i. Furthermore, "$x_{ij}$" denotes a relative position vector between the particle i and a particle j, and $x_{ij}$ is obtained by subtracting $x_j$ from $x_i$. Moreover, "$v_{ij}$" denotes a relative velocity vector between the particle i and the particle j, and $v_{ij}$ is obtained by subtracting $v_j$ from $v_i$. Furthermore, "$\mu_i$" denotes a viscosity coefficient, and $P_0$ is equal to $\rho_0 c^2$. Note that "c" denotes a sonic velocity, "$\rho_0$" denotes a standard density of the particle i, and when $\rho_i$ is equal to $\rho_0$, a pressure becomes 0. Furthermore, "W" denotes a kernel function or a weight function, and a spline function described in Expression (4) below may be used, for example.

$$w(r,h) = \begin{cases} \left(1 - 1.5\left(\frac{r}{h}\right)^2 + 0.75\left(\frac{r}{h}\right)^3\right)\Big/\beta & 0 \le \frac{r}{h} < 1, \\ 0.25\left(2 - \frac{r}{h}\right)^3 \Big/ \beta & 1 \le \frac{r}{h} < 2, \qquad \cdots (4) \\ 0 & 2 \le \frac{r}{h}. \end{cases}$$

Here, "h" denotes a radius of influence between the particles and may be twice or three times as large as an average particle gap in an initial state, for example. Furthermore, "$\beta$" is a value adjusted such that total space integral quantity of the kernel function becomes 1. In a case of a two-dimensional space, the value is $0.7\pi h^2$, and in a case of a three-dimensional space, the value is $\pi h^3$.

The law of conservation of mass of Expression (1) above is an equation of time evolution in which density is increased when particles move close to one another whereas the density is reduced when the particles move away from one another. Furthermore, the equation of motion in Expression (2) and the equation of state in Expression (3) represent that, when the density is increased, a pressure is increased, and therefore, the particles receive repulsive force from one another.

The time change calculation unit 15 calculates Expressions (1) to (3) above for each infinitesimal time (dt) and stores resultant values in the storage unit 13. Specifically, the time change calculation unit 15 accumulates and stores states of the particles in the calculation region in each infinitesimal time in a predetermined simulation time in the storage unit 13 as simulation results.

Here, injection molding of resin will be described as an example of calculation of simulation of fluid to which a pressure is applied. FIG. 2 is a diagram illustrating fluid injection by a pressure. In the example of FIG. 2, a mold 21, for example, which is schematically illustrated is used as a calculation region in which a simulation calculation of fluid is to be performed, that is, a region to be analyzed. The mold 21 has an inflow port for pouring resin 22 which is fluid. Any material may be used to form the mold 21 as long as the same use purpose is achieved. For example, ceramic may be used. Furthermore, in the example of FIG. 2, a pressure of an injection molding machine which injects the resin 22 to the mold 21 is schematically illustrated as a pressure 23. A boundary surface between the inflow port of the mold 21 and a nozzle of the injection molding machine is defined as a boundary surface 24 which distinguishes an inside and an outside of the calculation region.

As a simulation calculation of fluid to which a pressure is to be applied, in a case of injection molding of resin, for example, a filling fraction of the resin 22 to the mold 21 is obtained as a simulation result. In the case of injection molding of resin, after the resin 22 is injected to some extent, the mold 21 is filled with the resin 22 by applying a further pressure, that is, an external pressure. In this case, a pressure, that is, an internal pressure, is applied from the resin 22 in the mold 21 to the inflow port of the mold 21. Furthermore, in the example of the resin injection molding, as a simulation result, a surface in which the resin 22 injected from opposite sides joins together in an annular cavity of the mold 21 is obtained, for example. This surface causes molding defective referred to as a weldline, and therefore, simulation is effectively performed to avoid the generation of the weldline.

In the example of FIG. 2, the resin 22 is injected from the injection molding machine to the mold 21 by the pressure 23. The resin 22 is injected into the cavity which is a space in which a molded item is to be formed through a sprue, a runner, and a gate of the mold 21 so that the cavity is filled with the resin 22. Here, the time change calculation unit 15 simulates a state of an inside of the mold 21 serving as the calculation region while reflecting particles flowing through the boundary surface 24 for each infinitesimal time, and stores results of the simulation in the storage unit 13.

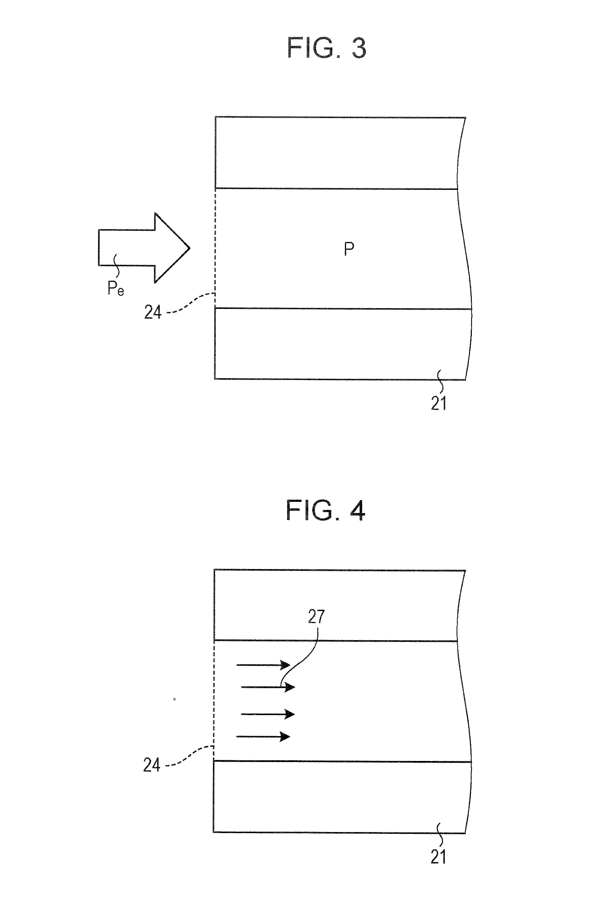

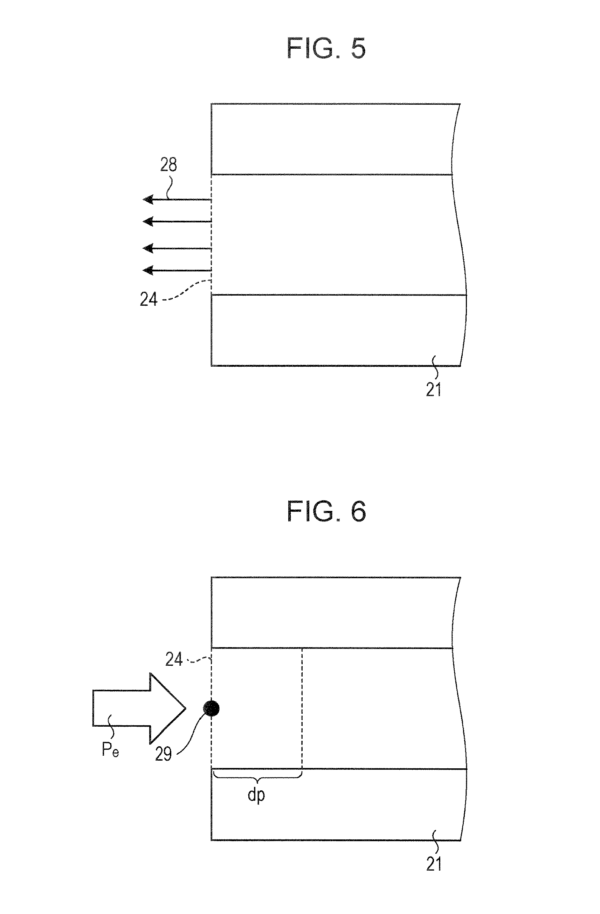

Here, a pressure applied to the boundary surface 24 will be described with reference to FIGs. 3 to 5. FIG. 3 is a diagram illustrating a pressure applied to the boundary face 24. As illustrated in FIG. 3, the boundary surface 24 is a boundary surface between the external pressure $P_e$ and the internal pressure P in the mold 21. FIG. 4 is a diagram illustrating a case where the external pressure $P_e$ overcomes the internal pressure P. In the example of FIG. 4, the external pressure $P_e$ is increased from the state of FIG. 3 and the external pressure $P_e$ overcomes the internal pressure P, that is, the external pressure $P_e$ is larger than the internal pressure P, for example. Accordingly, external fluid 27 flows into the mold 21 across the boundary surface 24. FIG. 5 is a diagram illustrating a case where the internal pressure P overcomes the external pressure $P_e$. In the example of FIG. 5, the internal pressure P is increased from the state of FIG. 3 and the internal pressure P overcomes the external pressure $P_e$, that is, the external pressure $P_e$ is smaller than the internal pressure P, for example. Accordingly, internal fluid 28 flows out of the mold 21 across the boundary surface 24.

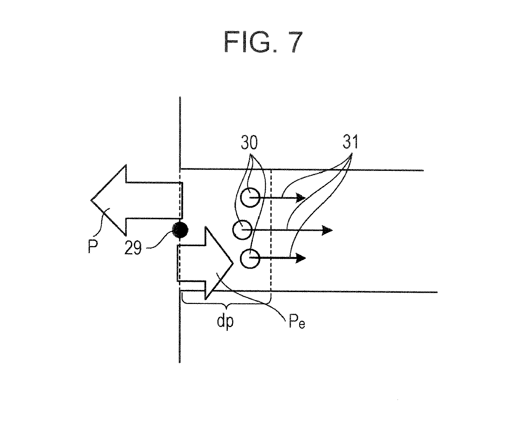

Next, the boundary surface 24 will be described with reference to FIGs. 6 and 7 taking a pressure into consideration. FIG. 6 is a diagram illustrating the relationship between a boundary particle and the external pressure $P_e$. As illustrated in FIG. 6, it is assumed that the inflow port of the mold 21 has a circular shape and a disk-like boundary particle 29 is disposed on the boundary surface 24. The boundary particle 29 moves into the mold 21 when the external pressure $P_e$ is applied to the boundary particle 29. The boundary particle 29 serves as the boundary surface 24, that is, a wall surface, and has a wall surface potential. An effective range of the wall surface potential is denoted by "dp". In other words, the boundary particle 29 disposed on the boundary surface 24 is a wall of a potential. FIG. 7 is a diagram illustrating force acting on the boundary particle 29. As illustrated in FIG. 7, if fluid particles 30 are included in the effective range dp of the wall surface potential of the boundary particle 29, for example, repulsive force 31 is applied to the individual particles 30 due to the wall surface potential of the boundary particle 29. Here, the external pressure $P_e$ and the internal pressure P which is reaction of a sum of the repulsive force 31 are applied to the boundary particle 29. Accordingly, the boundary particle 29 moves in accordance with the internal pressure P and the external pressure $P_e$. That is, the boundary particle 29 is a piston particle generator.

Referring back to FIG. 1, the repulsive force calculation unit 16 calculates repulsive force acting on a particle due to a wall surface potential of a boundary particle. Specifically, when the external pressure $P_e$ is input from the input unit 11, the repulsive force calculation unit 16 calculates the repulsive force 31 acting on the individual fluid particles 30 included in the effective range dp of the wall surface potential of the boundary particle 29.

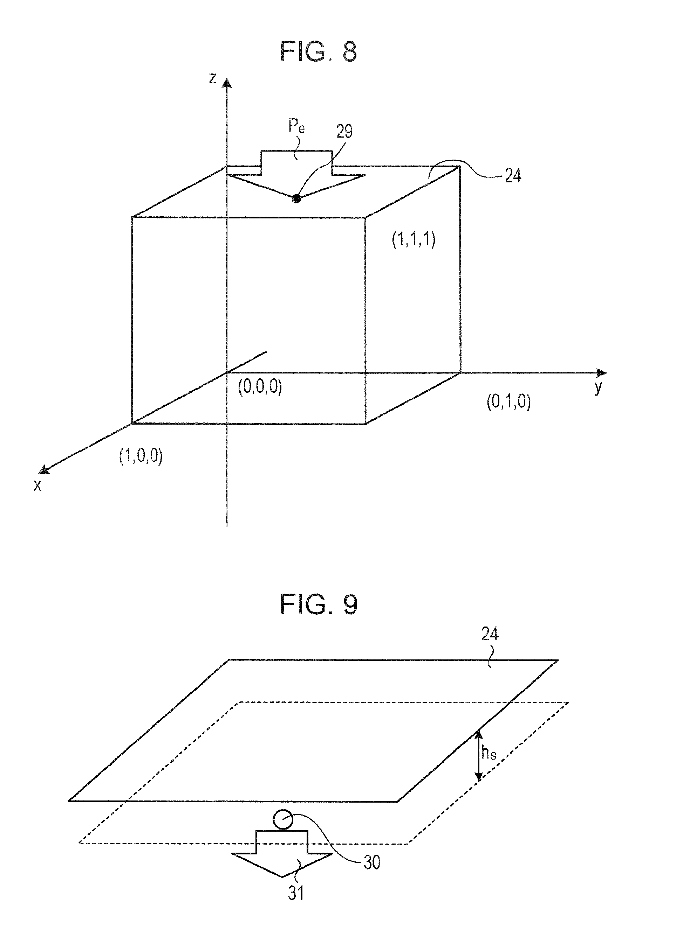

Here, force acting on the boundary particle 29 will be described. FIG. 8 is a diagram illustrating a calculation condition of force acting on the boundary particle 29. In FIG. 8, assuming that the calculation region has a square shape of $x \in (0, 1)$, $y \in (0, 1)$, and $z \in (0, 1)$ for simplicity, force acting on the boundary particle 29 will be described. First, as a boundary condition, it is assumed that the external pressure $P_e$ is applied to a surface of z=1, that is, the boundary surface 24. It is further assumed that a periodic boundary condition is set to the other boundaries. In this case, a force $F_Z(x_i)$ from the wall surface potential of the boundary surface 24 relative to the particle i, that is, the repulsive force 31 acting on the particle i is represented by Expression (5) below.

$$F_z(x_i) = \begin{cases} 0.1 \times \dfrac{c^2 m_i}{h_s}\left( \dfrac{1}{Z-h_s} - \dfrac{1}{Z-z_i} \right) & z_i > 1 - h_s \\ 0 & z_i \leq 1 - h_s \end{cases} \quad \cdots (5)$$

Here, "$h_s$" denotes the effective range of the wall surface potential, that is, "dp" of FIG. 7. Furthermore, "$z_i$" denotes a z component of a position vector of the particle i, "$m_i$" denotes a mass of the particle i, and "c" denotes a sonic velocity. Moreover, "Z" denotes a position of the wall surface and an initial value thereof is 1.

The repulsive force 31 acting on the particle i will be described with reference to FIG. 9. FIG. 9 is a diagram illustrating repulsive force acting on a particle due to a wall surface potential of the boundary particle. As illustrated in FIG. 9, when the particle i (the particle 30 in FIG. 9, for example) moves close to the surface of z=1, that is, the boundary surface 24, the repulsive force 31 is exerted in a direction away from the boundary surface 24 so that the particle i is not transmitted through the wall surface, that is, the boundary surface 24. Specifically, the repulsive force 31 is applied to the particle i in the effective range $h_s$ of the wall surface potential in the direction away from the boundary surface 24. In other words, the boundary surface 24 generates repulsive force due to the wall surface potential when fluid particles move close to the boundary surface 24 so as not to flow the fluid particles out of the boundary.

The repulsive force calculation unit 16 reads simulation results from the storage unit 13. The repulsive force calculation unit 16 updates a velocity, density, and a position of a fluid particle included in the calculation region which are the simulation results stored in the storage unit 13 in accordance with the read simulation results and the calculated repulsive force 31. The repulsive force calculation unit 16 updates the velocity, the density, and the position of the fluid particle included in the calculation region by calculating Expressions (1) to (3) above after adding Expression (5) to Expression (2) above. Furthermore, the repulsive force calculation unit 16 calculates a sum of the repulsive force 31 of all particles and outputs the sum to the position calculation unit 17. Note that the sum of the repulsive force 31 of all the particles is obtained by calculating $\Sigma F_Z(x_i)$ of a second member on a right-hand side of Expression (6) described below.

Referring back to FIG. 1, the position calculation unit 17 calculates the internal pressure P which is reaction of the repulsive force 31 based on the repulsive force 31 of all the particles input by the repulsive force calculation unit 16. Furthermore, the position calculation unit 17 calculates a position and a velocity of the boundary particle 29 in accordance with the maximum inflow velocity $v_{max}$ of the particle supplied from the input unit 11, the external pressure $P_e$, the area S of the inflow port, and the calculated internal pressure P. The position calculation unit 17 calculates a movement of the boundary particle 29 by Expression (6) below.

The movement of the boundary particle 29 is described with reference to FIG. 8 while it is assumed that the maximum inflow velocity of the particle on the boundary surface 24 which is the inflow surface is denoted by "$v_{max}$" and a diameter of the fluid particle is 0.1 as an initial condition. Furthermore, as the initial condition, the effective range $h_s$ of the wall surface potential is 0.1, that is, the effective range is equal to a diameter of the particle (a particle diameter) and particles having the diameter of 0.1 are disposed in positions far away from the boundary surface 24 by a distance corresponding to the effective range of the wall surface potential in the velocity $v_{max}$.

$$M\frac{d^2Z}{dt^2} = -p_e S - \sum_i F_z(x_i) \qquad \cdots (6)$$

Here, "Z" denotes a position of the boundary surface 24 in a z coordinate, "M" denotes a mass of the fluid included in the effective range of the wall surface potential and M is equal to $\rho_0 S h_s$. A first member on the right-hand side of Expression (6) above represents influence of the external pressure $P_e$. "S" denotes an area of the boundary surface 24 and is 1 in the example of FIG. 8. A second member on the right-hand side of Expression (6) above represents repulsive force acting on the fluid particle, that is, the internal pressure P in the fluid.

In Expression (6) above, the moving velocity V of the boundary surface 24 serving as the wall surface is represented by "V = dZ/dt" which denotes a velocity of the inflow fluid. As for the moving velocity V, Expression (6) is discretized at a time interval dt as illustrated in Expressions (7) to (9), for example, so that an inflow velocity (a velocity in a minus direction of an z axis in FIG. 8) does not exceed the maximum inflow velocity $v_{max}$ which is the maximum value.

$$V^{n,*} = V^n + dt\left(-p_e S - \sum_i F_z(x_i^n)\right) \qquad \cdots (7)$$

$$V^{n+1} = \max\left(-v_{max}, V^{n,*}\right) \qquad \cdots (8)$$

$$Z^{n+1} = Z^n + dt V^{n+1} \qquad \cdots (9)$$

Superscripts in Expressions (7) to (9) above represent the numbers of time steps. Here, assuming that a value of a time point n is given, Expressions (7) to (9) are used to calculate a value at a time point n+1. The position calculation unit 17 outputs the calculated position and the calculated moving velocity V of the boundary particle 29 to the particle generation/removal unit 18.

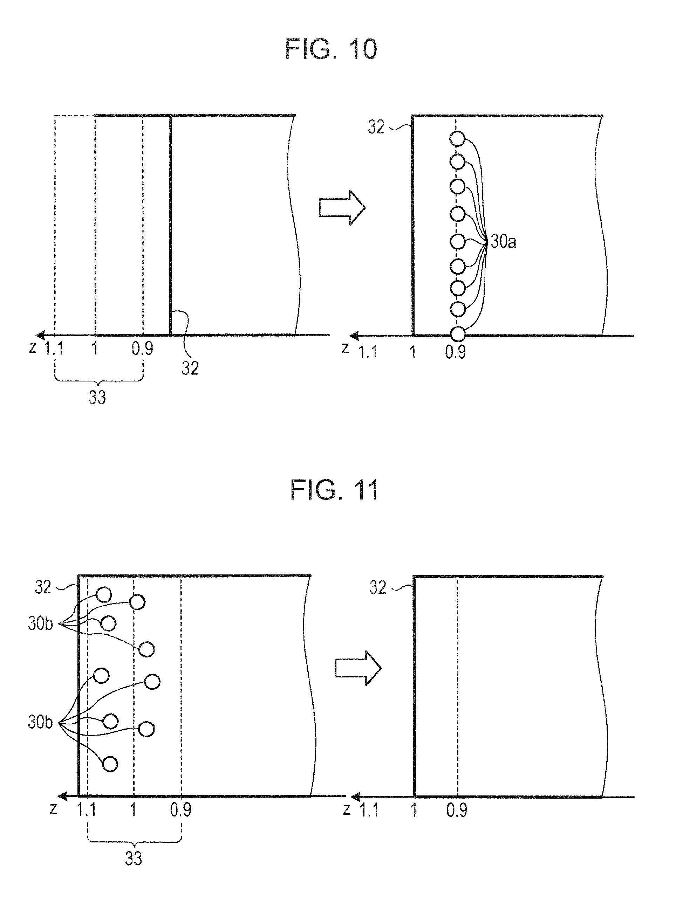

Referring back to FIG. 1, the particle generation/removal unit 18 generates or removes fluid particles in accordance with the position of the boundary particle 29 input by the position calculation unit 17. FIG. 10 is a diagram illustrating generation of particles on a boundary surface. In FIG. 10, an example of generation of fluid particles on a boundary surface is illustrated, and when the external pressure $P_e$ and the internal pressure P are balanced with each other, a wall surface 32 corresponding to the boundary surface 24 is located in a position 1 in the z axis which is an initial position. Furthermore, in FIG. 10, an effective range 33 of the wall surface potential of the boundary particle 29 is in a range between 0.9 and 1.1 in the z axis.

Here, when the external pressure $P_e$ becomes large, for example, the wall surface 32 is pushed by the external pressure $P_e$ as illustrated in a left portion of FIG. 10 so as to move in a minus direction in the z axis from the initial position z=1, that is, external fluid flows in the calculation region. When the wall surface 32 moves in a direction of an inside of the calculation region by the diameter of the fluid particle of 0.1 or more and exceeds the effective range 33 of the wall surface potential, the particle generation/removal unit 18 returns the wall surface 32 to the initial position (z=1) as illustrated in a right portion of FIG. 10. Furthermore, the particle generation/removal unit 18 generates particles 30a having a diameter of 0.1 and having a flow velocity of a z component corresponding to a moving velocity V of the wall surface 32 in positions on a surface of z=0.9, that is, a mesh position of 0.1 from the initial position. Specifically, the particle generation/removal unit 18 generates the particles 30a corresponding to a volume of the fluid pushed by the wall surface which is not affected by the wall surface potential. The generated particles 30a represent that external fluid flows in the calculation region. Note that the moving velocity V is input by the position calculation unit 17.

FIG. 11 is a diagram illustrating removal of particles on the boundary surface. In FIG. 11, an example of removal of fluid particles on the boundary surface is illustrated, and as with the case of FIG. 10, when the external pressure $P_e$ and the internal pressure P are balanced with each other, the wall surface 32 corresponding to the boundary surface 24 is located in the position 1 in the z axis which is the initial position. Furthermore, in FIG. 11, as with the case of FIG. 10, the effective range 33 of the wall surface potential of the boundary particle 29 is in a range between 0.9 and 1.1 in the z axis.

Here, when the internal pressure P becomes large, for example, the wall surface 32 is pushed by the internal pressure P as illustrated in a left portion of FIG. 11 so as to move in a plus direction in the z axis from the initial position z=1, that is, internal fluid flows out of the calculation region. When the wall surface 32 moves in a direction outside the calculation region by the diameter of the fluid particle of 0.1 or more and exceeds the effective range 33 of the wall surface potential, the particle generation/removal unit 18 returns the wall surface 32 to the initial position (z=1) as illustrated in a right portion of FIG. 11. Furthermore, the particle generation/removal unit 18 determines that particles 30b located in the effective range 33 of the wall surface potential, that is, a region between 0.9 and 1.1 in the z axis have flowed out of the calculation region and removes the particles 30b. The particle generation/removal unit 18 outputs information on the generated fluid particles 31a or the removed fluid particles 31b described above to the time change calculation unit 15 as particle data.

The generation or the removal of the particles on the boundary surface described above will now be described as a process performed by the particle generation/removal unit 18. The particle generation/removal unit 18 determines whether a movement amount of the wall surface 32, that is, the boundary particle 29 is smaller than the particle diameter of the fluid particles. When the movement amount of the boundary particle 29 is not smaller than the particle diameter of the fluid particles, the particle generation/removal unit 18 determines whether the boundary particle 29 has moved into the calculation region.

When the boundary particle 29 has moved into the calculation region, the particle generation/removal unit 18 generates fluid particles as illustrated in FIG. 10, for example, and outputs information on the generated fluid particles to the time change calculation unit 15 as particle data. When the boundary particle 29 has moved out of the calculation region, the particle generation/removal unit 18 removes fluid particles as illustrated in FIG. 11, for example, and outputs information on the removed fluid particles to the time change calculation unit 15 as particle data.

The particle generation/removal unit 18 determines whether the infinitesimal time (dt) serving as an analysis time has reached a predetermined time, that is, whether a calculation for a predetermined period of time has been completed in the simulation. When the calculation for the predetermined period of time has been completed, the particle generation/removal unit 18 determines that simulation results are obtained and terminates the process of the simulation apparatus 10. The simulation results may be displayed in the display unit 12.

When the calculation for the predetermined period of time has not been completed, the particle generation/removal unit 18 advances the infinitesimal time serving as the analysis time and instructs the time change calculation unit 15 to perform a simulation calculation of fluid in the next time step. Here, it is assumed that the predetermined period of time for the simulation is approximately 1 second to 5 seconds, that is, several seconds.

When the movement amount of the boundary particle 29 is smaller than the particle diameter of the fluid particles, the particle generation/removal unit 18 does not generate or remove the particles and determines whether the calculation for the predetermined period of time has been completed. When the calculation for the predetermined period of time has been completed, the particle generation/removal unit 18 determines that simulation results are obtained and terminates the process of the simulation apparatus 10. When the calculation for the predetermined period of time has not been completed, the particle generation/removal unit 18 advances the infinitesimal time (dt) serving as the analysis time and instructs the time change calculation unit 15 to perform a simulation calculation of fluid in the next time step.

Next, operation of the simulation apparatus 10 of this embodiment will be described.

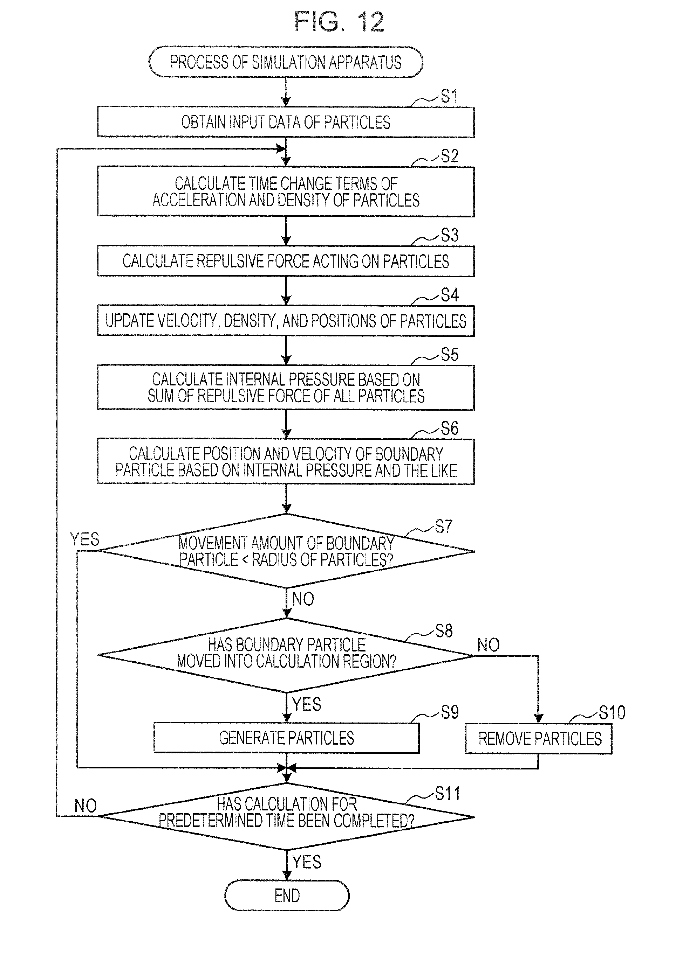

FIG. 12 is a flowchart illustrating a process of the simulation apparatus 10 according to the embodiment. When a user of the simulation apparatus 10 inputs data on a fluid particle used for the simulation, for example, the input unit 11 obtains the input data on the particle (step S1). As the input data, data on a shape of a simulation calculation region, fluid data, a maximum inflow velocity $v_{max}$ of the particle relative to the simulation calculation region, the external pressure $P_e$ for flowing the fluid into the calculation region, the area S of the inflow port, and the like are input, for example. The input unit 11 outputs the shape data, the fluid data, the maximum inflow velocity $v_{max}$, the external pressure $P_e$, and the area S of the inflow port to the controller 14 as input data externally input.

The time change calculation unit 15 of the controller 14 calculates Expressions (1) to (3) above for a certain infinitesimal time using the shape data, the fluid data, and so on input from the input unit 11 and stores resultant values in the storage unit 13 as simulation results. Specifically, the time change calculation unit 15 calculates time change members of acceleration and density of the particle (step S2).

When the external pressure $P_e$ is input from the input unit 11, the repulsive force calculation unit 16 calculates the repulsive force 31 acting on the individual fluid particles 30 included in the effective range 33 of the wall surface potential of the boundary particle 29 (step S3). Subsequently, the repulsive force calculation unit 16 reads the simulation results from the storage unit 13. The repulsive force calculation unit 16 updates a velocity, density, and positions of the fluid particles 30 included in the calculation region which are simulation results stored in the storage unit 13 in accordance with the read simulation results and the calculated repulsive force 31 (step S4). Specifically, the repulsive force calculation unit 16 updates the velocity, the density, and the positions of the fluid particles 30 included in the calculation region by calculating Expressions (1) to (3) described above after adding Expression (5) to Expression (2) described above. Furthermore, the repulsive force calculation unit 16 calculates a sum of the repulsive force 31 of all the particles and outputs the sum to the position calculation unit 17.

The position calculation unit 17 calculates the internal pressure P which is reaction of the repulsive force 31 based on the repulsive force 31 of all the particles supplied from the repulsive force calculation unit 16 (step S5). Furthermore, the position calculation unit 17 calculates a position and a velocity of the boundary particle 29 using Expressions (7) to (9) in accordance with the maximum inflow velocity $v_{max}$ of the particle supplied from the input unit 11, the external pressure $P_e$, the area S of the inflow port, and the calculated internal pressure P (step S6). The position calculation unit 17 outputs the calculated position and the calculated moving velocity V of the boundary particle 29 to the particle generation/removal unit 18.

The particle generation/removal unit 18 determines whether a movement amount of the boundary particle 29 is smaller than the particle diameter of the fluid particles (step S7). When the movement amount of the boundary particle 29 is not smaller than the particle diameter of the fluid particles (No in step S7), the particle generation/removal unit 18 determines whether the boundary particle 29 has moved into the calculation region (step S8). When the movement amount of the boundary particle 29 is smaller than the particle diameter of the fluid particles (Yes in step S7), the particle generation/removal unit 18 does not generate or remove particles and proceeds to step S11 described below.

When the boundary particle 29 has moved into the calculation region (Yes in step S8), the particle generation/removal unit 18 generates fluid particles as illustrated in FIG. 10, for example, and outputs information on the generated fluid particles to the time change calculation unit 15 as particle data (step S9). When the boundary particle 29 has moved out of the calculation region (No in step S8), the particle generation/removal unit 18 removes fluid particles as illustrated in FIG. 11, for example, and outputs information on the removed fluid particles to the time change calculation unit 15 as particle data (step S10).

The particle generation/removal unit 18 determines whether a calculation for a predetermined period of time has been completed in simulation (step S11). When the calculation for the predetermined period of time has been completed (Yes in step S11), the particle generation/removal unit 18 determines that simulation results are obtained and terminates the process of the simulation apparatus 10. When the calculation for the predetermined period of time has not been completed (No in step S11), the particle generation/removal unit 18 advances the infinitesimal time (dt) serving as the analysis time, return to step S2, and instructs the time change calculation unit 15 to perform a simulation calculation of fluid in the next time step. Specifically, when the user inputs the initial condition, the controller 14 repeatedly performs the process from step S2 to step S11 for the period of time used for the simulation and stores results of the simulation in the storage unit 13. Here, the number of times the process is repeatedly performed in the simulation, that is, the number of loops may be approximately 10 thousands to one million, for example. Accordingly, the simulation apparatus 10 may set an inflow amount of fluid taking a pressure into consideration and may reduce a calculation amount of simulation. Note that the predetermined period of time of the simulation and the number of loops are appropriately changed depending on a size of a model of the mold 21, for example.

As described above, the simulation apparatus 10 calculates time changes of fluid particles by the particle method so that repulsive force acting on the particles due to a wall surface potential of a boundary particle which represents a change of a pressure in an inflow port and which is disposed in the inflow port of a mold to be analyzed is calculated. Furthermore, the simulation apparatus 10 calculates an internal pressure of the mold which corresponds to reaction of the calculated repulsive force and calculates a position of the boundary particle in accordance with the calculated internal pressure and an external pressure which is a pressure for injecting particles to the mold. Furthermore, the simulation apparatus 10 generates or removes particles in accordance with a position of the boundary particle. Consequently, the simulation is performed at high speed. Specifically, the simulation apparatus 10 may reduce a calculation amount without degradation of calculation accuracy.

Furthermore, the simulation apparatus 10 calculates time changes of the particles in accordance with the particles generated or removed by the particle generation/removal unit 18. Accordingly, the simulation apparatus 10 may set an inflow amount of fluid taking a pressure into consideration and may reduce a calculation amount for simulation.

Moreover, when the boundary particle moves from an initial position into the mold by an amount corresponding to an effective range of the wall surface potential, the simulation apparatus 10 returns the boundary particle to the initial position and generates particles corresponding to a volume of the fluid which has been pushed out by the boundary particle.

Moreover, when the boundary particle moves from the initial position to an outside of the mold by the amount corresponding to the effective range of the wall surface potential, the simulation apparatus 10 returns the boundary particle to the initial position and removes particles included in the effective range of the wall surface potential in an inside and outside of the mold. Consequently, the fluid particles may be generated or removed in accordance with a movement of the boundary particle caused by the external pressure and the internal pressure.

Furthermore, the simulation apparatus 10 determines a range of a distance in which the boundary particle moves from the initial position to the inside of the mold and the outside of the mold as the effective range of the wall surface potential. Consequently, among fluid particles, a range in which the particles affect each other may be limited to an adjacent particle, and accordingly, a calculation amount may be reduced.

The simulation apparatus 10 calculates a moving velocity of the boundary particle so that the moving velocity does not exceed a maximum value of an inflow speed of the particles, and calculates a position of the boundary particle in accordance with the calculated moving velocity. As a result, an unrealistic fluid inflow velocity is not obtained, and a realistic simulation result may be obtained.

Although the SPH method is used as the particle method in the foregoing embodiment, the method is not limited to this. The embodiment is applicable to other particle methods. For example, the embodiment is similarly applicable to simulation employing a moving particle semi-implicit method. By this, in simulation of any type of particle method, the simulation may be performed at high speed.

Furthermore, although the injection molding of the resin is described in the foregoing embodiment as an example, the present technique is not limited to this. The present technique is applicable to simulation employing a metallic powder injection molding method and simulation employing a ceramic powder injection molding method, for example.

Furthermore, configurations of the components of the illustrated units are not physically limited to the illustrated configurations. Specifically, concrete formations of distribution and integration of the units are not limited to the illustrated formations, and all or some of the units may be physically distributed or integrated in an arbitrary unit depending on various loads, use states, and the like. For example, the time change calculation unit 15 and the repulsive force calculation unit 16 may be integrated as a single calculation unit which updates a velocity, density, and a position of a fluid particle included in a calculation region.

Furthermore, all or arbitrary some of the various processing functions of the units may be executed by a CPU (or a processor such as an MPU or a micro controller unit (MCU)). Moreover, all or arbitrary some of the various processing functions may be executed by a program analyzed and executed by the CPU (or the processor such as the MPU or the MCU) or hardware of a wired logic.

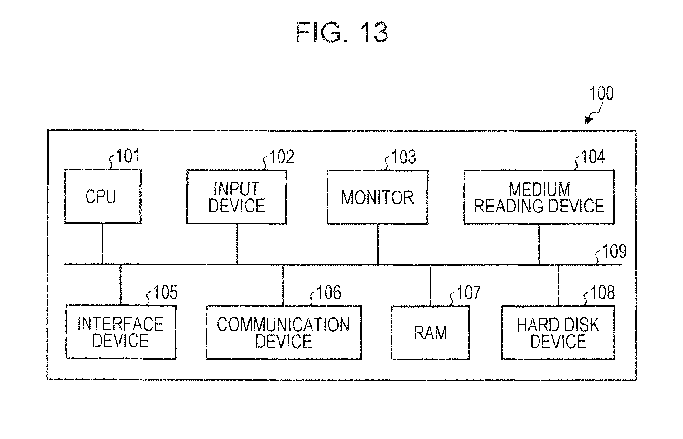

The various processes described in the foregoing embodiment may be realized by a computer which executes programs provided in advance. Hereinafter, an example of the computer which executes the programs having the same functions as the foregoing embodiment will be described. FIG. 13 is a diagram illustrating the computer which executes a simulation program.

As illustrated in FIG. 13, a computer 100 includes a CPU 101 which executes various calculation processes, an input device 102 which accepts data input, and a monitor 103. The computer 100 further includes a medium reading device 104 which reads programs and the like from a storage medium, an interface device 105 used to connect the computer 100 to various devices, and a communication device 106 used to connect the computer 100 to other information processing apparatuses and the like in a wired manner or a wireless manner. The computer 100 further includes a RAM 107 which temporarily stores various types of information and a hard disk device 108. The devices 101 to 108 are coupled to a bus 109.

The hard disk device 108 stores a simulation program having functions the same as those of the time change calculation unit 15, the repulsive force calculation unit 16, the position calculation unit 17, and the particle generation/removal unit 18 illustrated in FIG. 1. The hard disk device 108 further stores various data used to realize the simulation program. The input device 102 has a function the same as that of the input unit 11 illustrated in FIG. 1 and accepts input of various input data of simulation. The monitor 103 has a function the same as that of the display unit 12 illustrated in FIG. 1, and displays various screens, such as a simulation operation screen and a result screen. The interface device 105 is connected to a print apparatus, for example. The communication device 106 is connected to another information processing apparatus, for example, and transmits various information, such as information representing that the user operates the computer 100 by remote connection from a distant place or the like.

The CPU 101 reads various programs stored in the hard disk device 108, develops the programs in the RAM 107, and executes the programs so as to perform various processes. Furthermore, the programs may cause the computer 100 to function as the time change calculation unit 15, the repulsive force calculation unit 16, the position calculation unit 17, and the particle generation/removal unit 18 illustrated in FIG. 1.

Note that it is not necessarily the case that the simulation program described above is stored in the hard disk device 108. A program stored in a storage medium readable by the computer 100 may be read and executed by the computer 100, for example. Examples of the storage medium readable by the computer 100 include portable recording media, such as a CD-ROM, a DVD disc, and a universal serial bus (USB) memory, semiconductor memories, such as a flash memory, and a hard disk drive. Furthermore, the simulation program may be stored in an apparatus connected to a public line, the Internet, a local area network (LAN), or the like and the computer 100 may read the simulation program from the apparatus and execute the program.

**Claims**

1.  A simulation apparatus, comprising:

    a memory; and
    a processor coupled to the memory,
    wherein the processor executes:

        a time change process of calculating time changes of fluid particles by a particle method,
        a repulsive force process of calculating repulsive force acting on the particles due to a wall surface potential of a boundary particle which is disposed in an inflow port of a mold to be analyzed and which represents a change of a pressure in the inflow port,
        a position process of calculating a position of the boundary particle in accordance with an internal pressure of the mold which is reaction of the calculated repulsive force and an external pressure which injects the particles to the mold, and
        a particle process of generating or removing the particles in accordance with a position of the boundary particle.

2.  The simulation apparatus according to claim 1, wherein
    in the time change process, time changes of the particles are calculated in accordance with the particles generated or removed in the particle process.

3.  The simulation apparatus according to claim 1 or claim 2, wherein
    in the particle process, when the boundary particle moves into the mold from an initial position by an amount corresponding to an effective range of the wall surface potential, the boundary particle is returned to the initial position, and the particles corresponding to a volume of fluid pushed out by the boundary particle are generated, whereas when the boundary particle moves out of the mold from the initial position by an amount corresponding to the effective range of the wall surface potential, the boundary particle is returned to the initial position and the particles included in the effective range of the wall surface potential in an inside and an outside of the mold are removed.

4.  The simulation apparatus according to claim 3, wherein
    in the particle process, a range of a distance in which the boundary particle moves from the initial position to portions in the inside and the outside of the mold by a size of the boundary particle corresponds to the effective range of the wall surface potential.

5.  The simulation apparatus according to any one of claims 1 to 4, wherein
    in the position process, a moving velocity of the boundary particle is calculated so as not to exceed a maximum value of an inflow velocity of the particles in accordance with the internal pressure and the external pressure, and a position of the boundary particle is calculated in accordance with the calculated moving velocity.

6.  A simulation method employed in a computer, the simulation method comprising:

calculating time changes of fluid particles by a particle method;

calculating repulsive force acting on the particles due to a wall surface potential of a boundary particle which is disposed in an inflow port of a mold to be analyzed and which represents a change of a pressure in the inflow port;

calculating a position of the boundary particle in accordance with an internal pressure of the mold which is reaction of the calculated repulsive force and an external pressure which injects the particles to the mold; and

generating or removing the particles in accordance with a position of the boundary particle.

7. A non-transitory, computer-readable recording medium having stored therein a program for causing a computer to execute a process, the process comprising:

calculating time changes of fluid particles by a particle method;

calculating repulsive force acting on the particles due to a wall surface potential of a boundary particle which is disposed in an inflow port of a mold to be analyzed and which represents a change of a pressure in the inflow port;

calculating a position of the boundary particle in accordance with an internal pressure of the mold which is reaction of the calculated repulsive force and an external pressure which injects the particles to the mold; and

generating or removing the particles in accordance with a position of the boundary particle.

EP 2 919 140 A1

# FIG. 1

# FIG. 2

12

# FIG. 3

# FIG. 4

# FIG. 5

# FIG. 6

# FIG. 7

## FIG. 8

## FIG. 9

# FIG. 10

# FIG. 11

# FIG. 12

```
            ( PROCESS OF SIMULATION APPARATUS )
                          |
                          v                    ~S1
  +-------------------------------------------------+
  |         OBTAIN INPUT DATA OF PARTICLES          |
  +-------------------------------------------------+
                          |
      +------------------>|
      |                   v                    ~S2
      |   +-------------------------------------------------+
      |   |        CALCULATE TIME CHANGE TERMS OF           |
      |   |    ACCELERATION AND DENSITY OF PARTICLES        |
      |   +-------------------------------------------------+
      |                   |
      |                   v                    ~S3
      |   +-------------------------------------------------+
      |   |    CALCULATE REPULSIVE FORCE ACTING ON PARTICLES |
      |   +-------------------------------------------------+
      |                   |
      |                   v                    ~S4
      |   +-------------------------------------------------+
      |   | UPDATE VELOCITY, DENSITY, AND POSITIONS OF PARTICLES |
      |   +-------------------------------------------------+
      |                   |
      |                   v                    ~S5
      |   +-------------------------------------------------+
      |   |       CALCULATE INTERNAL PRESSURE BASED ON      |
      |   |     SUM OF REPULSIVE FORCE OF ALL PARTICLES     |
      |   +-------------------------------------------------+
      |                   |
      |                   v                    ~S6
      |   +-------------------------------------------------+
      |   |   CALCULATE POSITION AND VELOCITY OF BOUNDARY   |
      |   | PARTICLE BASED ON INTERNAL PRESSURE AND THE LIKE|
      |   +-------------------------------------------------+
      |                   |
      |                   v                    ~S7
      |  YES         /  MOVEMENT AMOUNT OF BOUNDARY  \
      |<------------<  PARTICLE < RADIUS OF PARTICLES? >
      |              \                              /
      |                   | NO
      |                   v                    ~S8
      |            /   HAS BOUNDARY PARTICLE   \      NO
      |           <  MOVED INTO CALCULATION REGION? >------+
      |            \                          /            |
      |                   | YES                            |
      |                   v         ~S9          ~S10      v
      |        +-------------------+      +-------------------+
      |        | GENERATE PARTICLES |      | REMOVE PARTICLES |
      |        +-------------------+      +-------------------+
      |                   |                            |
      |                   v<---------------------------+
      |                   |                    ~S11
      |  NO      /   HAS CALCULATION FOR   \
      +---------< PREDETERMINED TIME BEEN COMPLETED? >
                 \                          /
                          | YES
                          v
                      (  END  )
```

# FIG. 13

100

| 101 | 102 | 103 | 104 |
| CPU | INPUT DEVICE | MONITOR | MEDIUM READING DEVICE |

109

| 105 | 106 | 107 | 108 |
| INTERFACE DEVICE | COMMUNICATION DEVICE | RAM | HARD DISK DEVICE |

Europäisches
Patentamt

European
Patent Office

Office européen
des brevets

# EUROPEAN SEARCH REPORT

Application Number

EP 15 15 8024

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | XU XIAOYANG ET AL: "SPH simulations of three-dimensional non-Newtonian free surface flows", COMPUTER METHODS IN APPLIED MECHANICS AND ENGINEERING, NORTH-HOLLAND, AMSTERDAM, NL, vol. 256, 31 December 2012 (2012-12-31), pages 101-116, XP028981281, ISSN: 0045-7825, DOI: 10.1016/J.CMA.2012.12.017 * the whole document, note in particular section 3.3. Boundary conditions and section 4.3. Simulation of injection molding * | 1-7 | INV. G06F17/50 B29C45/76 |
| A | JINLIAN REN ET AL: "Simulation of complex filling process based on the generalized Newtonian fluid model using a corrected SPH scheme", COMPUTATIONAL MECHANICS ; SOLIDS, FLUIDS, ENGINEERED MATERIALS, AGING INFRASTRUCTURE, MOLECULAR DYNAMICS, HEAT TRANSFER, MANUFACTURING PROCESSES, OPTIMIZATION, FRACTURE & INTEGRITY, SPRINGER, BERLIN, DE, vol. 49, no. 5, 7 December 2011 (2011-12-07), pages 643-665, XP035044378, ISSN: 1432-0924, DOI: 10.1007/S00466-011-0669-3 * the whole document, note in particular section 3.3.3 Inflow boundary condition and section 5 The simulation of complex filling process * | 1-7 | |

TECHNICAL FIELDS
SEARCHED       (IPC)

G06F
B29C

The present search report has been drawn up for all claims

| Place of search | Date of completion of the search | Examiner |
|---|---|---|
| Munich | 24 April 2015 | Lerbinger, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)